# EUROPEAN PATENT SPECIFICATION

(11) **EP 3 134 925 B1**
(45) Date of publication and mention of the grant of the patent: **11.07.2018**
(21) Application number: 15717887.2
(22) Date of filing: 22.04.2015
(51) Int. Cl.: H01L 41/047, H02N 2/00, H02N 2/02

(54) **PIEZOELEKTRIC ACTUATOR**
PIEZOELEKTRISCHER AKTOR FÜR EINEN ULTRASCHALLMOTOR
ACTIONNEUR PIÉZOÉLECTRIQUE POUR UN MOTEUR ULTRASONIQUE

(30) Priority: 25.04.2014 EP 14166036
(43) Date of publication of application: 01.03.2017
(73) Proprietor: Physik Instrumente (PI) GmbH & Co. KG, 76228 Karlsruhe (DE)
(72) Inventor: KOC, Burhanettin, 76275 Ettlingen (DE)
(74) Representative: Grünecker Patent- und Rechtsanwälte PartG mbB
(86) International application number: PCT/EP2015/058640
(87) International publication number: WO 2015/162146

(56) References cited:
- DE-A1-102008 012 992
- JP-A- 2010 172 196

## Description

This invention relates to a piezoelectric actuator according to claims 1 to 9 and to a method for driving such a piezoelectric actuator according to the claims 10 to 13.

The patent document US 5,932,952 A describes a structure of a piezoelectric motor with a vibrating stator element comprising an elastic bar with machined two projection friction tips on one large surface of the elastic bar and with two or four small piezoelectric patch actuators that are attached on the other large surface of the bar. The patch actuators are driven with two phase signals and cause the elastic bar to vibrate in longitudinal and in bending mode directions using first longitudinal and fourth bending vibration mode. Said two kind of vibrations lead to an elliptical motion of the two projection friction tips, which is transferred to the slider element.

It is well known in the art that usage of elastic material in a vibration stator element can decrease the coupling coefficient, resulting in a decrease of efficiency of the corresponding piezoelectric ultrasonic motor. Additionally, due to the difference of thermal expansion coefficient of piezoelectric and elastic elements, a high stress concentration takes place at the bonding layer possibly causing detachment of the piezoelectric plate from the elastic surface.

The patent documents US 6,798,117 B2 and US 7,067,958 B2 teach a motor structure using four multilayered actuators that are isolated and attached on a surface. Corresponding structures of the vibrating elements are relatively complex and costly. Even though it could have large force, the piezoelectric actuators need to be driven at audible frequency (quasi-static). When the motor operates, there exists always an audible noise coming from the motor. The speeds of these motors are also slow (maximum up to 10 mm/s) such that these motors can only be used in applications where high speed is not required.

In order to make a motor operate, a sufficient displacement of the piezoelectric multilayer actuators needs to be generated. To generate a sufficient displacement, a relatively long actuator with a high number of layers is needed. Even if a high number of layers is used, these motors are still operated at relatively high voltages or potentials, respectively (more than 100V).

Sometimes, a four actuator body is manufactured as a single element with the actuators being isolated from each other by a cutting process. Said cutting process can create additional reliability problems and performance degradation due to crack generation at sharp edges. Therefore, structure of these motors cannot be miniaturized and their driving voltage cannot be reduced at a reasonable cost.

Piezoelectric motors that operate by exciting first longitudinal and second bending modes of a rectangular bar are known from patent documents US 7,501,741 B2 and US 7,764,449 B2. The excited second bending modes are either in thickness or in width direction. In order to tune first longitudinal mode into second thickness (or width bending) mode, a certain length to thickness (or width) ratio, which is about 3.5, is used.

When making a vibrating piezoelectric plate in multilayer form, and in case of second bending mode in thickness direction, it is preferred that the layer thickness is as thin as possible for a low driving voltage (typically from 3 to 5 V). In case the plate length is, for example, 25 mm, the required thickness for a vibrator is about 7 mm. When each layer thickness is selected as 50 µm, a total number of 140 layers of piezoelectric sheets has to be stacked. The only way to reduce vibrator thickness is using shorter length, which means higher frequency driving of the motor. High frequency driving is generally more problematic in terms of electrical driving, control and isolation of the wiring.

Further devices are known from JP 2010-172196 A and DE 10 2008 012992 A1.

It is the task of the invention to provide a piezoelectric actuator that overcomes the above described disadvantages of piezoelectric actuators of corresponding motors according to the state of the art.

Said task is solved by a piezoelectric actuator according to claim 1, with the following sub-claims 2 to 10 comprising at least appropriate configurations and developments.

Thus, a piezoelectric actuator for an ultrasonic motor in the shape of a plate is assumed with two, in terms of area, largest main surfaces, with two longer and two shorter side surfaces, and with the side surfaces connecting the main surfaces. The longer side surfaces run in the length direction of the plate, and the short side surfaces run in the width direction of the plate, with the width direction being perpendicular to the length direction. The thickness direction of the plate-shaped piezoelectric actuator is perpendicular to the length and the width direction of the plate.

At one of the main surfaces, at least one friction element is arranged, which is intended for mechanical or friction contact with an element to be driven by the piezoelectric actuator. The piezoelectric actuator in the form of a plate has at least three layers of uniformly polarized piezoelectric material stacked in its thickness direction and at least one electrode layer arranged at a main surface constituting outer electrodes and at least two electrode layers each arranged between two adjacent piezoelectric material layers and constituting inner electrodes.

The inner electrodes comprise exciting electrodes and common electrodes and the outer electrodes comprise exciting electrodes and at least one common electrode. Adjacent electrode layers have different electrodes, i.e. a first electrode layer, for example, has or constitutes exciting electrodes, and the corresponding adjacent or second electrode layer has or constitutes a common electrode, and the corresponding adjacent or third electrode layer has or constitutes again exciting electrodes and so on. With other words, each inner piezoelectric material layer has on its two main and oppositely arranged surfaces different kind of electrodes (exciting electrodes and common electrode or common electrodes). At least one of the exciting electrode has two first channel electrodes and two second channel electrodes with the first channel electrodes and the second channel electrodes being alternately arranged along the length direction of the plate in a spaced and separated manner, and the area of each separated electrode together with the surrounding region of the piezoelectric actuator in its thickness direction defining four separate sections of the plate, each section representing a generator for a standing wave, where the polarization direction of adjacent piezoelectric material layers of each generator is opposite to each other.

With such structured piezoelectric actuator, the combined or independent electrical excitation of the first longitudinal mode and the fourth bending or flexural mode within the piezoelectric actuator, i.e. the piezoelectric actuator acting itself as a resonator, is easily possible. The main advantage of using said combination of modes is that the piezoelectric plate thickness could be very thin. In general, with such a piezoelectric actuator, a corresponding motor can be almost 5 times thinner for a given length of the piezoelectric plate.

For a length of 25 mm, e.g., the required thickness of a piezoelectric actuator according to the proposed structure is about 1.5 mm. If the layer thickness is typically selected as 50 µm, only 30 layers are needed with the inventive piezoelectric actuator. The usage of less number of layers considerably reduces the manufacturing costs.

Using the fourth bending or flexural mode to generate the needed normal displacements has other advantages, too. The wavelength of the fourth flexural mode is shorter compared to the second flexural mode; therefore, maximum displacement point in normal or thickness direction is closer to the end of the plate with respect to its length direction. Since displacement in longitudinal direction is the largest at the two ends of the plate, a larger displacement both in normal and tangential directions at the contact point is generated.

Having the friction element(s) and, correspondingly, the contact point away from the centre of the plate is preferable with respect to the holding and the electrical soldering of the piezoelectric actuator. Since the centre of the piezoelectric actuator is a nodal position for both first longitudinal and fourth flexural mode, the holding and electrical soldering positions at said position can minimize the disturbance to the movement or vibration at the friction contact point(s).

It may prove useful that the positions of the first channel electrodes and of the second channel electrodes of adjacent exciting electrodes are inverted with adjacent electrodes being stacked in the thickness direction of the piezoelectric actuator. Said inversion means that at the lengthwise position of a first channel electrode of a given exciting electrode (layer), a second channel electrode is arranged in an adjacent exciting electrode (layer) and so forth.

It may also prove useful that the first channel electrodes and/or the second channel electrodes of an exciting electrode are integrally formed or formed as one piece, respectively. This enhances the electrical connectivity of the first and second channel electrodes.

Besides, it may prove useful that the first channel electrodes and the second channel electrodes of an exciting electrode are arranged in an intersecting manner.

Furthermore, it may prove useful that all first channel electrodes are electrically connected together and that all second channel electrodes are electrically connected together.

In addition, it may prove useful that the area of at least one common electrode nearly corresponds to the area of a main surface.

Moreover, it may prove useful that the outer electrodes comprise two exciting electrodes and two common electrodes.

It may prove advantageous that the outer electrodes at least partially cover the main surface and the longer side surface and the shorter side surface.

Furthermore, it may prove advantageous that the friction element is arranged with a space to the corresponding shorter side surface by one fifth of the length of the plate.

Besides, it may prove advantageous that the length to thickness ratio of the plate is about 17.

The invention relates also to a method for driving the piezoelectric actuator according to the preceding advantageous embodiments.

In this context, a method to drive such a piezoelectric actuator is assumed with a driving or signal voltage being applied either in between the first channel electrodes and the common electrodes or in between the second channel electrodes and the common electrodes.

Here, it may prove useful that the application of the driving or signal voltage is such that the electrically excited areas of the piezoelectric actuator within a plane oriented perpendicular to its main surfaces have a zig-zag-pattern with respect to the length direction of the piezoelectric actuator.

It may also prove useful that a first driving voltage is applied in between the exciting electrodes independently exciting flexural mode vibrations of the piezoelectric actuator and that a second driving voltage is applied in between the common electrodes independently exciting longitudinal mode vibrations of the piezoelectric actuator.

In addition, it may prove useful that the first longitudinal mode and the fourth bending mode of the piezoelectric actuator are excited.

Furthermore, it may prove useful that the volume of the electrically excited areas of the piezoelectric actuator corresponds to the half of the volume of the piezoelectric actuator. Thus, only within half of the volume of the piezoelectric actuator heat will be generated due to electrical excitation and thus lowering the degradation of the performance of the piezoelectric actuator and enhancing its reliability.

The invention will now be described with reference to the appended drawings:
Fig. 1 is an exploded perspective view of the piezoelectric actuator according to a first embodiment of the invention
Fig. 2 shows the electrode connectivity of the piezoelectric actuator according to Fig. 1 with excitation of the first channel electrodes and with the second channel electrodes floating (one-phase excitation)
Fig. 3 shows the electrode connectivity of the piezoelectric actuator according to Fig. 1 with excitation of the second channel electrodes and with the first channel electrodes floating (one-phase excitation)
Fig. 4 shows a two-phase excitation of the piezoelectric actuator according to Fig. 1 with independent electrical ground
Fig. 5 is an exploded perspective view of the piezoelectric actuator according to another embodiment of the invention
Fig. 6 is a perspective view of the piezoelectric actuator according to another embodiment of the invention with a multilayer structure according to Fig. 5
Fig. 7 is a perspective view of the piezoelectric actuator according to Fig. 6 showing its lower surface
Fig. 8a shows the electrical connectivity for the polarization of the piezoelectric actuator according to Figs. 6 and 7
Fig. 8b shows the polarization direction of the single piezoelectric material layers of the piezoelectric actuator after application of the polarization method according to Fig. 8a
Fig. 9 possible electrical connectivity for the piezoelectric actuator according to Figs. 6 to 8a or 8b, respectively
Fig. 10 another possible electrical connectivity for the piezoelectric actuator according to Figs. 6 to 8a or 8b, respectively

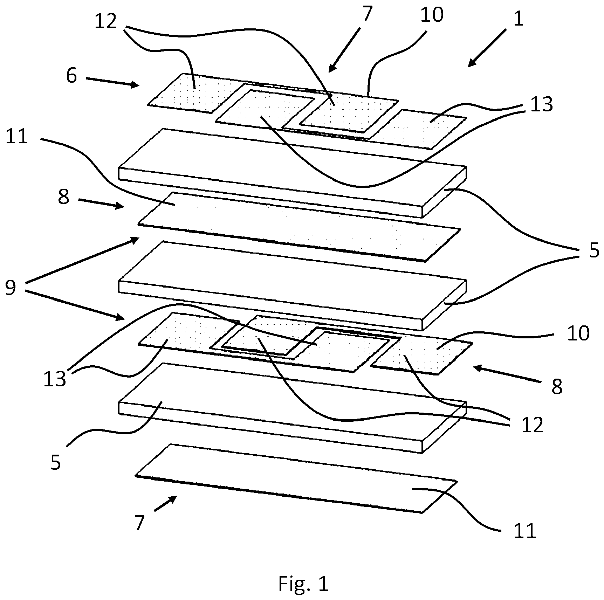

Fig. 1 shows a piezoelectric actuator 1 according to a first embodiment of the invention in an exploded perspective view. Said piezoelectric actuator has a three-layer structure, i.e. it has three layers 5 of a uniformly polarized piezoelectric material, thus the piezoelectric material of each layer 5 has only one poling direction. In addition, the piezoelectric actuator has four electrode layers 6 whereof two are outer electrodes 7 and whereof two are inner electrodes 9. One of the outer electrodes 7, i.e. the uppermost electrode layer in Fig. 1, is an exciting or active electrode 10. The other outer electrode, which is the lowermost layer in Fig. 1, is a common electrode 11. The exciting or active electrode, as well as the common electrode, is made from an electrically conductive material.

In an analogous manner, one of the inner electrodes 9 is an exciting electrode 10, and the other of the inner electrodes is a common electrode 11. The exciting electrodes 10 and the common electrodes 11 are alternately ranged, and in each case separated from another by a layer of piezoelectric material 5. Each of the exciting electrodes 10 has two first channel electrodes 12 and two second channel electrodes 13 with the first channel electrodes 12 and the second channel electrodes 13 alternately arranged along the length direction of the piezoelectric actuator in a spaced manner, i.e. along the length direction of the piezoelectric actuator, a first channel electrode 12 is followed by a second channel electrode 13, which itself is followed by a first channel electrode 12 that is again followed by a second channel electrode 13, and where adjacent electrodes are separated and isolated from one another by a space arranged between them.

The two first channel electrodes 12 have a quadratic shape and are integrally connected by a narrow bridge portion, i.e. the two first channel electrodes are made in one piece, with the bridge portion pairing and electrically connecting the two first channel electrodes 12. The two first channel electrodes 12, being spaced from another and connected by said bridge portion, substantially constitute an U-form or U-shape with the first channel electrodes forming the side legs and with the bridge portion forming the lower leg. Analogously, the two second channel electrodes 13 also have a quadratic shape and are also integrally connected by a narrow bridge portion, thus also being made in one piece, with the bridge portion also pairing and electrically connecting the two second channel electrodes 13. Furthermore, the two second channel electrodes 13, being spaced from another and connected by said bridge portion, substantially constitute an U-form or U-shape, too, with the second channel electrodes 13 forming the side legs, and with the bridge portion forming the lower leg.

The two fist channel electrodes and the two second channel electrodes are arranged in an intersecting manner with the narrow bridge portions being arranged on different, i.e. opposite, sides. With other words, the lower legs of the U-forms are arranged on opposite sides, and the side legs of one U-form are facing in a different, i.e. opposite, direction as the side legs of the other U-form. The surface of the intersecting first channel electrodes and second channel electrodes of an exciting electrode is nearly equal to the surface of an adjacent layer of piezoelectric material.

The position of the first channel electrodes and the second channel electrodes of the outer exciting electrode is different to the position of the first channel electrodes and the second channel electrodes of the inner exciting electrode with respect to the length direction of the piezoelectric actuator, with the positions of the first channel electrodes and of the second channel electrodes of the outer electrode and the inner electrode being inverted.

With other words: related to the lengthwise direction, at the position of a first channel electrode of the outer electrode is a second channel electrode of the inner electrode and vice versa, or, to describe it differently, the first channel electrodes and the second channel electrodes of adjacent exciting electrodes are shifted against each other substantially by the width of a first channel electrode or of a second channel electrode.

The common electrodes 11 are shaped such that they have no openings and that they substantially cover the whole surface of the adjacent layer of piezoelectric material.

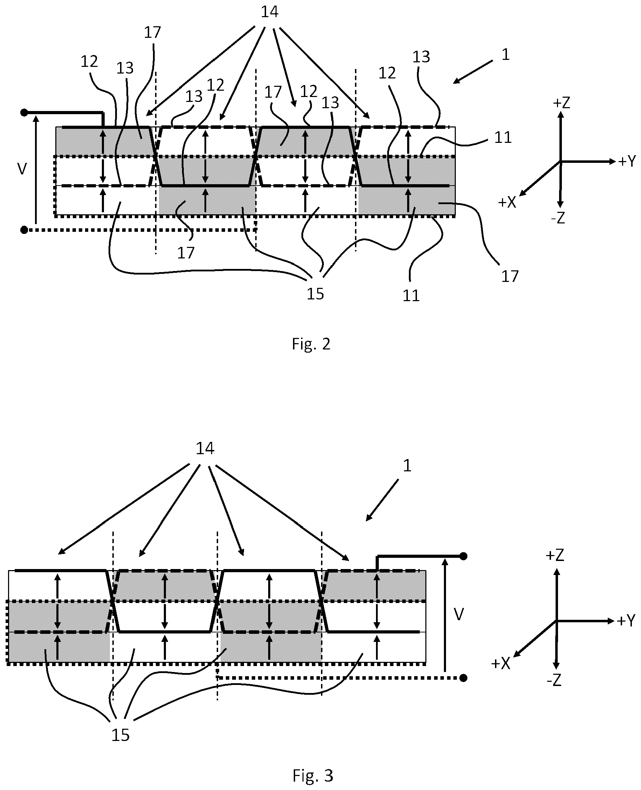

Fig. 2 shows the electrode connectivity of the piezoelectric actuator according to Fig. 1 with excitation of the first channel electrodes by a cross-sectional view. As can be seen, a driving electrical signal or voltage V, respectively, is applied in between the first channel electrodes 12 and the common electrodes 11, with the common electrodes 11 being electrically grounded, while the second channel electrodes 13 are potential-free and thus floating. Thus the excitation method of Fig. 2 represents a one-phase excitation or driving method.

All first channel electrodes 12 are electrically connected, and all second channel electrodes 13 are electrically connected, too. Besides, all common electrodes 11 are electrically connected.

The structure of the exciting electrodes substantially consisting of four plate-shaped and respectively spaced electrodes (first and second channel electrodes) defines four separate sections 14 in the lengthwise direction of the piezoelectric actuator, each section - in its thickness direction - comprising a first channel electrode, a second channel electrode, a corresponding portion of the common electrodes overlapping with the area of the first channel electrode and/or the second channel electrode, and a corresponding portion of the piezoelectric material layers overlapping with the area of the first channel electrode and/or the second channel electrode. The space portion between adjacent first channel electrodes and second channel electrodes of one exciting electrode defines the separation between adjacent separate sections 14.

The arrows in Fig. 2 define the polarization direction of the different portions of the piezoelectric material. According to this, the polarization direction is in each case normal, i.e. either in +Z-direction or in -Z-direction, to the corresponding electrode. Moreover, the polarization direction of adjacent piezoelectric material layers is opposite, i.e. anti-parallel, where the polarization direction within a layer is uniform and thus without a change in the polarization direction. Analogously, the polarization direction of adjacent piezoelectric material layers of each section 14 is also opposite or anti-parallel, respectively.

The shaded portions in Fig. 2 show those areas 17 of the piezoelectric actuator being excited when the voltage signal is applied in between the first channel electrodes and the common electrodes. It can be seen that the excited areas 17 - with respect to the plane perpendicularly arranged to the main surfaces of the piezoelectric actuator - follow a zig-zag pattern in the length direction of the piezoelectric actuator with the excited area in each section 14 being formed between the first channel electrodes and the adjacent portions of the common electrodes. From Fig. 2, it also follows that - while applying a driving voltage in between the first channel electrodes and the common electrodes - only half of the area of the piezoelectric actuator is excited, and correspondingly, only half of the volume of the piezoelectric actuator is excited.

With the above described excitation of the piezoelectric actuator, the first longitudinal mode and the fourth flexural or bending mode can be simultaneously excited, thereby causing an oblique motion of a friction element being arranged at a main surface of the piezoelectric actuator.

Fig. 3 is nearly identical to Fig. 2, except for the fact that here the driving voltage is applied in between the second channel electrodes and the common electrodes. Thus, the description above for Fig. 2 is analogously applicable. It follows that the excited areas 17 of the piezoelectric actuator are formed between the second channel electrodes and the common electrodes, also following a zig-zag pattern with respect to the length direction of the piezoelectric actuator, where the corresponding zig-zag pattern is shifted by substantially a fourth of the length of the piezoelectric actuator compared to the zig-zag pattern of Fig. 2. In other words, the zig-zag pattern is shifted substantially by the width of a section 14.

With the above described excitation of the piezoelectric actuator, the first longitudinal mode and the fourth flexural or bending mode can also be simultaneously excited, thereby causing an oblique motion of a friction element being arranged at a main surface of the piezoelectric actuator. However, the direction of the oblique motion is inversely oriented compared to the oblique motion of a corresponding friction element according to the excitation method of Fig. 2.

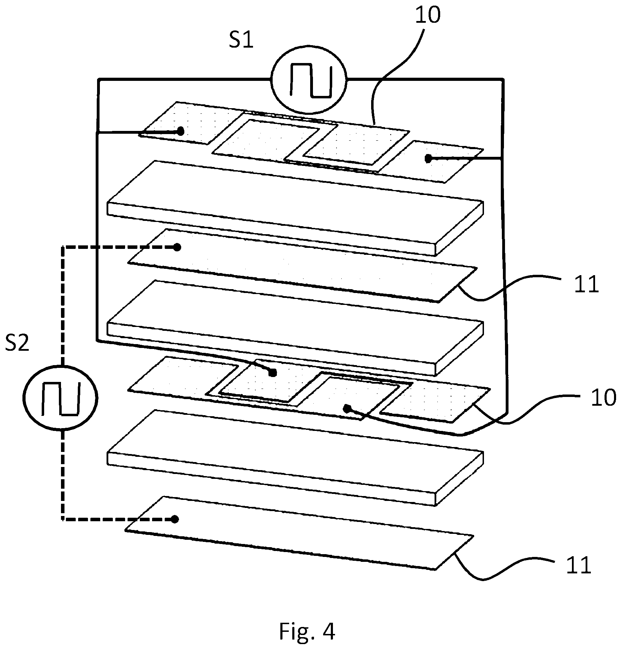

Fig. 4 shows a two-phase excitation or driving method of the piezoelectric actuator according to Fig. 1. Here, the piezoelectric actuator is driven with two sinusoidal signals or voltages, respectively, where a first signal S1 is applied in between the first channel electrodes and the second channel electrodes of each exciting electrode, and where a second signal S2 is applied in between the common electrodes. As regards the first signal S1, said signal is applied to the outer exciting electrode and in between those electrodes of the first channel electrodes and the second channel electrodes arranged near to the shorter side surfaces, as well as to the inner exciting electrode in between those electrodes of the first channel electrodes and the second channel electrodes being arranged adjacent to each other.

The signal S1 generates only bending or flexural mode vibrations, whereas the signal S2 only generates longitudinal mode vibrations. As a result, motions in longitudinal and in flexural directions can be excited independently. Here, it is also possible to arrange a friction element at a shorter side surface of the piezoelectric actuator.

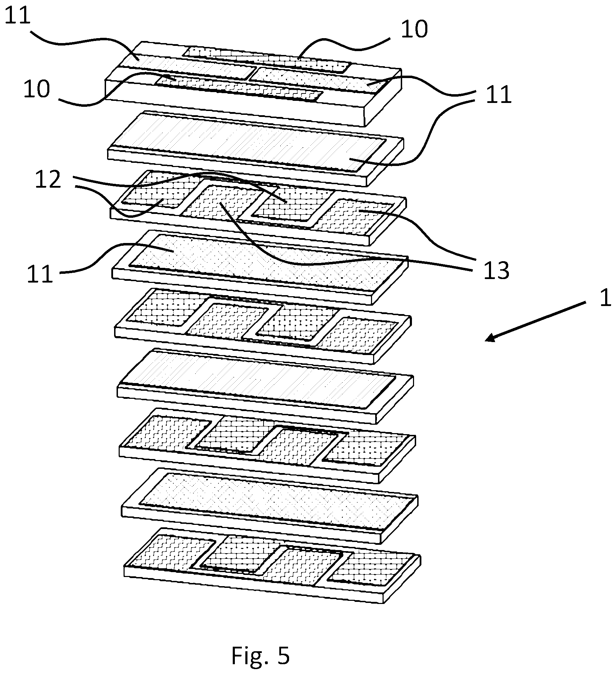

Fig. 5 is an exploded perspective view of the piezoelectric actuator according to another embodiment of the invention. This piezoelectric actuator has nine piezoelectric material layers, i.e. a nine-layer structure.

From top to down in Fig. 5, the piezoelectric actuator has a first layer of piezoelectric material comprising two exciting electrodes 10 and two common electrodes 11 as outer electrodes arranged on its upper main surface with the lower main surface having no electrode. The exciting electrodes 10 as well as the common electrodes 11 have an elongated form and are stripe-shaped. While the common electrodes are arranged in the middle-part of the upper main surface with each of them reaching with one side (the shorter side) the shorter side surface of the piezoelectric material layer, the exciting electrodes are arranged such that each of them reaches with one side (the longer side) to the longer side surface of the piezoelectric material layer.

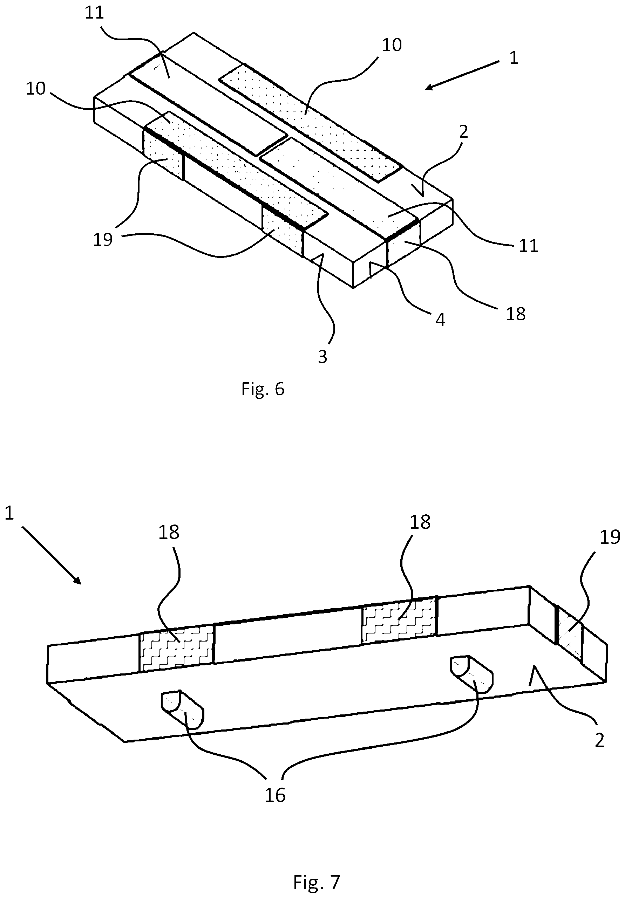

The second layer has a common electrode as inner electrode arranged on its upper main surface with no electrode arranged at the lower main surface. The area of the inner common electrode nearly covers the whole surface of the second piezoelectric material layer with a small gap between the common electrode and three of the side surfaces, namely the longer side surfaces 3 (see Fig. 6) and one of the shorter side surfaces 4 (see Fig. 6), of the piezoelectric material layer. With other words, the inner common electrode does with three of its sides not reach to the side surface of the piezoelectric material layer, while the corresponding fourth side does reach to the corresponding side surface, i.e. one of the shorter side surfaces (see Fig. 6) of the piezoelectric material layer.

The third layer of piezoelectric material has an exciting electrode comprising two first channel electrodes and two second channel electrodes as inner electrode arranged on its upper main surface with no electrode arranged at the lower main surface. The structure and arrangement of the first channel electrodes and the second channel electrodes arranged at the third layer is identical to that of the first channel electrodes and the second channel electrodes of the exciting electrodes of the piezoelectric actuator according to Figs. 1 to 4, where the first channel electrodes reach to one longer surface of the piezoelectric material layer and the second channel electrodes reach to the other and opposite longer side surface of the piezoelectric material layer. Besides, neither the first channel electrodes, nor the second channel electrodes reach another side surface of the piezoelectric material layer and correspondingly are spaced to the other side surfaces of the piezoelectric material layer.

The fourth layer has a common electrode as inner electrode arranged on its upper main surface having no electrode at its lower main surface. The area of the inner common electrode nearly covers the whole surface of the second piezoelectric material layer with a small gap between the common electrode and three of the side surfaces, namely the longer side surfaces 3 (see Fig. 6) and one of the shorter side surfaces 4 (see Fig. 6), of the piezoelectric material layer, thus reaching with one of its sides to a shorter side surface of the piezoelectric material layer. The side of the common electrode of the fourth layer reaching the corresponding shorter side surface of the piezoelectric actuator is oppositely arranged to the side of the common electrode of the second layer reaching the corresponding shorter side surface of the piezoelectric material layer or the piezoelectric actuator, respectively. The aforesaid is generally valid for the piezoelectric actuator of Fig. 5, i.e. the side of each inner common electrode reaching the corresponding shorter side surface of the piezoelectric material layer is oppositely arranged for adjacent inner common electrodes, i.e. while one inner common electrode reaches to one of the shorter side surfaces of the piezoelectric actuator, the adjacent inner common electrode(s) reach(es) to the other and opposite shorter side surface of the piezoelectric actuator.

The fifth layer has an exciting electrode as inner electrode arranged on its upper main surface and no electrode at its lower main surface, where the arrangement of the first channel electrodes and the second channel electrodes is identical to that of the exciting electrode of the third layer.

The sixth layer has a common electrode as inner electrode arranged on its upper main surface with no electrode arranged at its lower main surface. The geometry and arrangement of the common electrode of the sixth layer is identical to that of the second layer.

The seventh layer has an exciting electrode as inner electrode arranged on its upper main surface with no electrode arranged at its lower main surface. The geometry or shape of the first channel electrodes and the second channel electrodes is identical to the geometry of the first channel electrodes and the second channel electrodes of the fifth or third layer; however, the positions of the first channel electrodes and the second channel electrodes of the seventh layer with respect to the length direction of the piezoelectric actuator are inverted compared to the positions of the first channel electrodes and the second channel electrodes of the fifth or third layer.

The eighth layer has a common electrode as inner electrode arranged on its upper main surface having no electrode arranged at its lower main surface. The eighth layer identically repeats the fourth layer.

The ninth layer identically repeats the seventh layer and has an exciting electrode as inner electrode arranged on its upper main surface. No electrode is arranged at the lower main surface of the ninth layer.

In analogy to the three-layered piezoelectric actuator according to Fig. 1, the structure of the exciting electrodes substantially consisting of four plate-shaped and respectively spaced electrodes (first and second channel electrodes) defines four separate sections in the lengthwise direction of the piezoelectric actuator, each section comprising - with regard to its thickness direction - two first channel electrodes, two second channel electrodes, corresponding portions of the inner common electrodes overlapping with the area of the first channel electrodes and the second channel electrodes, and corresponding portions of the piezoelectric material layers overlapping with the area of the first channel electrodes and the second channel electrodes of each section.

Fig. 6 is a perspective view of the piezoelectric actuator according to another embodiment of the invention with an inner multilayer structure according to Fig. 5 and with an identical electrode arrangement as regards the upper main surface of the piezoelectric actuator, i.e. with elongated and stripe-shaped exciting and common electrodes having two longer sides and two shorter sides, where the two common electrodes are arranged one after another in the length direction of the piezoelectric actuator with a separating gap between them and with one of the common electrodes reaching with one of its shorter sides to the respective short side surface of the piezoelectric actuator and with the other of the common electrodes reaching with one of its shorter sides to the other and oppositely arranged short side surface of the piezoelectric actuator.

The two common electrodes are arranged between the two exciting electrodes with one of the exciting electrodes reaching with one of its longer sides to one of the longer side surfaces of the piezoelectric actuator and with the other of the exciting electrodes reaching with one of its longer sides to the other and oppositely arranged longer side surface of the piezoelectric actuator.

As described before, each of the common electrodes reaches with one of its shorter sides to the corresponding short side surface of the piezoelectric actuator, thereby (electrically) contacting a corresponding side electrode 18 arranged at the respective short side surface. Over said side electrodes 18, an electrical connection between the outer common electrodes and the inner common electrodes is realized.

Besides, each of the exciting electrodes reaches with one of its longer sides to the corresponding long side surface of the piezoelectric actuator, thereby (electrically) contacting two corresponding side electrodes 19 arranged at the respective long side surface. Over said side electrodes 19, an electrical connection between the outer exciting electrodes and the inner exciting electrodes is realized.

Fig. 7 shows the piezoelectric actuator according to Fig. 6 from another perspective view, thus showing the other (lower) main surface, where two friction elements 16 are arranged. The space between each friction element 16 and the adjacent short side surface of the piezoelectric actuator is equal to a fifth of the length of the piezoelectric actuator.

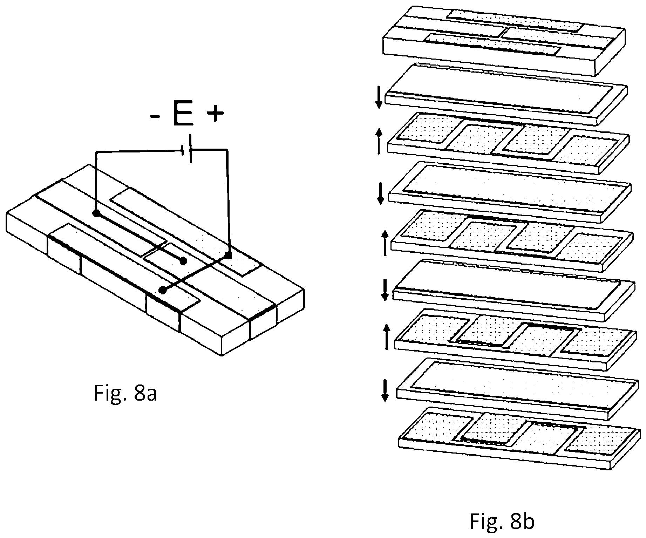

Fig. 8a shows a possible electrical contacting or driving method for the polarization of the piezoelectric material layers of the piezoelectric actuator according to Figs. 6 and 7, where the negative pole of an electrical DC power supply is connected to both of the outer common electrodes and where the positive pole of the same electrical DC power supply is connected to both of the outer exciting electrodes. By this contacting or driving method, the piezoelectric material layers can be polarized at one single step.

Fig. 8b shows the polarization directions of the single piezoelectric material layers of the piezoelectric actuator polarized by the method according to Fig. 8a. As can be seen, each piezoelectric material layer has a polarization direction that is opposite to the polarization direction of its adjacent layers.

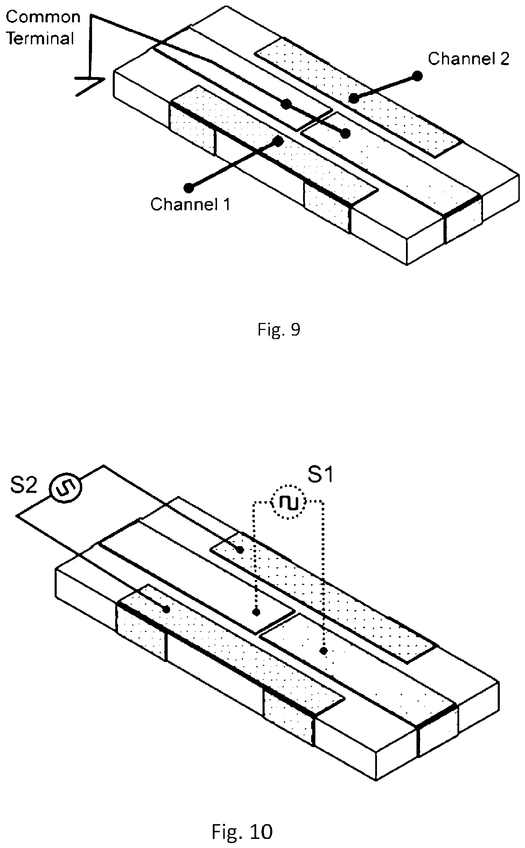

Fig. 9 shows a possible electrical connectivity as regards the piezoelectric actuator according to Figs. 6 to 8a or 8b, respectively. Here, the driving electrical signal is either applied in between the first channel electrodes (designated as Channel 1 in Fig. 9) and the common electrodes, or in between the second channel electrodes (designated as Channel 2 in Fig. 9) and the common electrodes. The outer common electrodes are shorted and act as one single outer electrode. By this kind of electrical connectivity, the first longitudinal and the fourth bending or flexural mode is excited in the piezoelectric actuator at the same time.

Fig. 10 shows another possible electrical connectivity as regards the piezoelectric actuator according to Figs. 6 to 8a or 8b, respectively. Here, the piezoelectric actuator is driven by two phase signals with independent grounds. While one signal (S2) is applied in between the outer exciting electrodes, the other signal (S1) is applied in between the outer common electrodes. The S2-signal excites only flexural or bending mode vibrations, while the S1-signal generates only longitudinal mode vibrations. Since said modes are excited independently, magnitudes of the vibration in flexural and longitudinal direction are independently excitable.

## Claims

1. Piezoelectric actuator (1) for an ultrasonic motor in the shape of a plate with two main surfaces (2) representing the largest surfaces of the plate, where at least one friction element (16) is arranged at one of said main surfaces, two longer side surfaces (3) running in the length direction of the plate and two shorter side surfaces (4) running in the width direction of the plate, the plate having at least three layers (5) of uniformly polarized piezoelectric material stacked in its thickness direction and at least one electrode layer (6) arranged at a main surface constituting outer electrodes (7) and at least two electrode layers (8) each arranged between two adjacent piezoelectric material layers and constituting inner electrodes (9), with the inner electrodes (9) comprising exciting electrodes (10) and common electrodes (11) and with the outer electrodes (7) comprising exciting electrodes (10) and at least one common electrode (11), and with adjacent electrode layers (8) constituting different electrodes, and with at least one exciting electrode having two first channel electrodes (12) and two second channel electrodes (13) with the first channel electrodes and the second channel electrodes alternately arranged along the length direction of the plate in a spaced manner and thus defining four separate sections (14) of the plate, each section representing a generator (15) for a standing wave, and with the polarization direction of adjacent piezoelectric material layers of each generator being opposite to each other.

2. Piezoelectric actuator according to claim 1, **characterized in that** the position of the first channel electrodes (12) and of the second channel electrodes (13) of adjacent exciting electrodes (10) is inverted.

3. Piezoelectric actuator according to claim 1 or 2, **characterized in that** the first channel electrodes (12) and/or the second channel electrodes (13) of an exciting electrode (10) are integrally formed.

4. Piezoelectric actuator according to claim 3, **characterized in that** the first channel electrodes (12) and the second channel electrodes (13) of an exciting electrode (10) are arranged in an intersecting manner.

5. Piezoelectric actuator according to one of the preceding claims, **characterized in that** all first channel electrodes (12) are electrically connected together and that all second channel electrodes (13) are electrically connected together.

6. Piezoelectric actuator according to one of the preceding claims, **characterized in that** the area of at least one common electrode (11) nearly corresponds to the area of a main surface (2).

7. Piezoelectric actuator according to one of the preceding claims, **characterized in that** the outer electrodes (7) comprise two exciting electrodes (10) and two common electrodes (11).

8. Piezoelectric actuator according to one of claims 1 to 7, **characterized in that** the friction element (16) is spaced to the corresponding shorter side surface (4) by one fifth of the length of the plate.

9. Piezoelectric actuator according to one of the preceding claims, **characterized in that** the length to thickness ratio of the plate is about 17.

10. Method to drive the piezoelectric actuator according to one of the preceding claims, **characterized in that** a driving voltage is applied either in between the first channel electrodes (12) and the common electrodes (11) or in between the second channel electrodes (13) and the common electrodes (11).

11. Method according to claim 10, **characterized in that** the application of a driving voltage is such that the electrically excited areas (17) of the piezoelectric actuator within a plane oriented perpendicular to its main surfaces follow a zig-zag-pattern in the lengthwise direction of the piezoelectric actuator.

12. Method according to claim 10 or 11, **characterized in that** the first longitudinal mode and the fourth bending mode of the piezoelectric actuator are excited.

13. Method according to one of the claims 10 to 12, **characterized in that** the volume of the electrically excited areas of the piezoelectric actuator corresponds to the half of the volume of the piezoelectric actuator.

## Patentansprüche

1. Piezoelektrischer Aktuator (1) für einen Ultraschall-Motor in der Form einer Platte mit zwei Hauptflächen (2), welche die größten Flächen der Platte repräsentieren, an dem zumindest ein Reibelement (16) an einer von diesen Hauptflächen angeordnet ist, zwei längere Seitenflächen (3), die in der Längsrichtung der Platte verlaufen, und zwei kürzerer Seitenflächen (4), die in der Breitenrichtung der Platte verlaufen, die Platte hat zumindest drei Schichten (5) von gleichförmig polarisiertem piezoelektrischen Material, gestapelt in deren Dickenrichtung, und zumindest eine Elektrolytschicht (6), die an einer Hauptfläche angeordnet ist, welche äußere Elektroden (7) bildet, und zumindest zwei Elektrodenschichten (8), die jede zwischen zwei benachbarten piezoelektrischen Materialschichten angeordnet sind, und innere Elektroden (9) bilden, mit den inneren Elektroden (9), welche Erregerelektroden (10) und gemeinsame Elektroden (11) umfassen, und mit den äußeren Elektroden (7), welcher Erregerelektroden (10) und zumindest eine gemeinsame Elektrode (11) umfassen, und mit benachbarten Elektrodenschichten (8), welche unterschiedliche Elektroden bilden, und mit zumindest einer Erregerelektrode, die zwei erste Kanalelektroden (12) und zwei zweite Kanalelektroden (13) hat, mit den ersten Kanalelektroden und den zweiten Kanalelektroden abwechselnd angeordnet entlang der Längsrichtung der Platte in beabstandeter Weise, und so vier getrennte Abschnitte (14) der Platte definieren, jeder Abschnitt repräsentiert einen Generator (15) für eine stehende Welle, und mit der Polarisationsrichtung von benachbarten piezoelektrischen Materialschichten von jedem Generator gegenüberliegend zueinander.

2. Piezoelektrischer Aktuator gemäß Anspruch 1, **dadurch gekennzeichnet, dass** die Position der ersten Kanalelektroden (12) und der zweiten Kanalelektroden (13) von benachbarten Erregerelektroden (10) invertiert ist.

3. Piezoelektrischer Aktuator gemäß Anspruch 1 oder 2, **dadurch gekennzeichnet, dass** die ersten Kanalelektroden (2) und/oder die zweiten Kanalelektroden (13) von den Erregerelektroden (10) integral ausgebildet sind.

4. Piezoelektrischer Aktuator gemäß Anspruch 3, **dadurch gekennzeichnet, dass** die ersten Kanalelektroden (12) und die zweiten Kanalelektroden (13) von einer Erregerelektrode (10) in einer sich schneidenden Weise angeordnet sind.

5. Piezoelektrischer Aktuator gemäß einem der vorangehenden Ansprüche, **dadurch gekennzeichnet, dass** alle ersten Kanalelektroden (12) elektrisch miteinander verbunden sind, und dass alle zweiten Kanalelektroden (13) elektrisch miteinander verbunden sind.

6. Piezoelektrischer Aktuator gemäß einem der vorangehenden Ansprüche, **dadurch gekennzeichnet, dass** der Bereich von zumindest einer gemeinsamen Elektrode (11) nahezu dem Bereich einer Hauptfläche (2) entspricht.

7. Piezoelektrischer Aktuator gemäß einem der vorangehenden Ansprüche, **dadurch gekennzeichnet, dass** die äußeren Elektroden (7) zwei Erregerelektroden (10) und zwei gemeinsame Elektroden (11) umfassen.

8. Piezoelektrischer Aktuator gemäß einem der Ansprüche 1 bis 7, **dadurch gekennzeichnet, dass** das Reibelement (16) zu der korrespondierenden kürzeren Seitenfläche (4) ein Fünftel der Länge der Platte beabstandet ist.

9. Piezoelektrischer Aktuator gemäß einem der vorangehenden Ansprüche, **dadurch gekennzeichnet, dass** das Längen-zu-Dicken-Verhältnis der Platte etwa 17 ist.

10. Verfahren zum Antrieb des piezoelektrischen Aktuators gemäß einem der vorangehenden Ansprüche, **dadurch gekennzeichnet, dass** eine Antriebsspannung entweder zwischen den ersten Kanalelektroden (12) und den gemeinsamen Elektroden (11) oder zwischen den zweiten Kanalelektroden (13) und den gemeinsamen Elektroden (11) aufgebracht ist.

11. Verfahren gemäß Anspruch 10, **dadurch gekennzeichnet, dass** Aufbringen der Antriebsspannung so ist, dass die elektrisch angeregten Bereiche (17) des piezoelektrischen Aktuators in einer Ebene sind, die senkrecht zu dessen Hauptflächen orientiert ist, einem Zick-Zack-Muster in der Längsrichtung des piezoelektrischen Aktuators folgen.

12. Verfahren gemäß Anspruch 10 oder 11, **dadurch gekennzeichnet, dass** die erste Längs-Mode und die vierte Biege-Mode des piezoelektrischen Aktuators angeregt sind.

13. Verfahren gemäß einem der Ansprüche 10 bis 12, **dadurch gekennzeichnet, dass** das Volumen der elektrisch angeregten Bereiche des piezoelektrischen Aktuators der Hälfte des Volumens des piezoelektrischen Aktuators entspricht.

## Revendications

1. Actionneur piézoélectrique (1) pour un moteur ultrasonique en forme de plaque plate avec deux surfaces principales (2) représentant les plus grandes surfaces de la plaque, dans lequel au moins un élément de frottement (16) est agencé sur l'une desdites surfaces principales, deux surfaces latérales plus longues (3) qui s'étendent en direction de la longueur de la plaque et deux surfaces latérales plus courtes (4) qui s'étendent en direction de la largeur de la plaque, la plaque comportant au moins trois couches (5) de matériau piézoélectrique uniformément polarisé empilées en direction de son épaisseur, au moins une couche d'électrode (6) agencée sur une surface principale constituant des électrodes externes (7), et au moins deux couches d'électrode (8) agencées chacune entre deux couches de matériau piézoélectrique adjacentes et constituant des électrodes internes (9), les électrodes internes (9) comprenant des électrodes d'excitation (10) et des électrodes communes (11), les électrodes externes (7) comprenant des électrodes d'excitation (10) et au moins une électrode commune (11), les couches d'électrode adjacentes (8) constituant différentes électrodes, au moins une électrode d'excitation comportant deux électrodes de premier canal (12) et deux électrodes de deuxième canal (13), les électrodes de premier canal et les électrodes de deuxième canal étant agencées alternativement en direction de la longueur de la plaque de manière espacée et définissant ainsi quatre sections séparées (14) de la plaque, chaque section représentant un générateur (15) pour une onde stationnaire, les directions de polarisation des couches de matériau piézoélectrique adjacentes de chaque générateur étant opposées entre elles.

2. Actionneur piézoélectrique selon la revendication 1, **caractérisé en ce que** les positions des électrodes de premier canal (12) et des électrodes de deuxième canal (13) d'électrodes d'excitation adjacentes (10) sont inversées.

3. Actionneur piézoélectrique selon la revendication 1 ou 2, **caractérisé en ce que** les électrodes de premier canal (12) et/ou les électrodes de deuxième canal (13) d'une électrode d'excitation (10) sont conformées de manière intégrée.

4. Actionneur piézoélectrique selon la revendication 3, **caractérisé en ce que** les électrodes de premier canal (12) et les électrodes de deuxième canal (13) d'une électrode d'excitation (10) sont agencées de manière à s'intersecter.

5. Actionneur piézoélectrique selon l'une des revendications précédentes, **caractérisé en ce que** toutes les électrodes de premier canal (12) sont connectées électriquement entre elles et toutes les électrodes de deuxième canal (13) sont connectées électriquement entre elles.

6. Actionneur piézoélectrique selon l'une des revendications précédentes, **caractérisé en ce que** la surface d'au moins une électrode commune (11) correspond presque à la surface d'une surface principale (2).

7. Actionneur piézoélectrique selon l'une des revendications précédentes, **caractérisé en ce que** les électrodes externes (7) comprennent deux électrodes d'excitation (10) et deux électrodes communes (11).

8. Actionneur piézoélectrique selon l'une des revendications 1 à 7, **caractérisé en ce que** l'élément de frottement (16) est espacé de la surface latérale plus courte correspondante (4) d'un cinquième de la longueur de la plaque.

9. Actionneur piézoélectrique selon l'une des revendications précédentes, **caractérisé en ce que** le ratio longueur/épaisseur de la plaque est d'environ 17.

10. Procédé de commande de l'actionneur piézoélectrique selon l'une des revendications précédentes, **caractérisé en ce qu'**une tension de commande est appliquée soit entre les électrodes de premier canal (12) et les électrodes communes (11), soit entre les électrodes de deuxième canal (13) et les électrodes communes (11).

11. Procédé selon la revendication 10, **caractérisé en ce que** l'application d'une tension de commande est telle que les surfaces électriquement excitées (17) de l'actionneur piézoélectrique dans un plan orienté perpendiculairement à ses surfaces principales suit un motif en zigzag en direction de la longueur de l'actionneur piézoélectrique.

12. Procédé selon la revendication 10 ou 11, **caractérisé en ce que** le premier mode longitudinal et le quatrième mode de flexion de l'actionneur piézoélectrique sont excités.

13. Procédé selon l'une des revendications 10 à 12, **caractérisé en ce que** le volume des surfaces électriquement excitées de l'actionneur piézoélectrique correspond à la moitié du volume de l'actionneur piézoélectrique.
